# EUROPEAN PATENT SPECIFICATION

(11) **EP 1 090 446 B1**
(45) Date of publication and mention of the grant of the patent: **17.04.2002**
(21) Application number: 99926745.3
(22) Date of filing: 10.06.1999
(51) Int. Cl.: H02G 3/02, H05K 5/02, H02G 3/04

(54) **ELEMENTS TO COVER CABLES, CASES, SHELLS, PANELS, AND CHANNEL TO COVER CABLES, PARTICULARLY FOR ELECTRIC AND/OR ELECTRONIC APPARATUSES USED ON A WORKING PLANE**
ABDECKUNGSELEMENTE FÜR KABEL, GEHÄUSE, GEHÄUSESCHALEN, WANDBEKLEIDUNGEN, UND KABELABDECKUNG FÜR AUF EINER ARBEITFLÄCHE STEHENDE ELEKTRISCHE UND/ODER ELEKTRONISCHE GERÄTE
ELEMENTS, ENVELOPPES, COQUES, PANNEAUX ET CANAUX PERMETTANT DE RECOUVRIR DES CABLES, EN PARTICULIER POUR DES APPAREILS ELECTRIQUES ET/OU ELECTRONIQUES SITUES SUR UN PLAN DE TRAVAIL

(30) Priority: 12.06.1998 IT CL980004; 23.10.1998 IT RM980672; 01.03.1999 IT CL990001
(43) Date of publication of application: 11.04.2001
(73) Proprietor: Formuso, Giuseppe, 93100 Caltanissetta (IT)
(72) Inventor: Formuso, Giuseppe, 93100 Caltanissetta (IT)
(74) Representative: Sarpi, Maurizio
(86) International application number: IT9900170
(87) International publication number: WO9965126

(56) References cited:
- EP-A- 0 010 277
- EP-A- 0 511 822
- WO-A-89/04591
- US-A- 5 286 919

## Description

The present invention relates to elements to cover cables, cases, shells, panels, and channels to cover cables, particularly for electric and/or electronic apparatuses provided on a working plane and like or on a floor.

More particularly. the invention relates to elements of the above kind allowing to cover both the functional components and the rear panel for the connection cables of the apparatus. and all the cable connection panels. in any position they are provided and the power and/or connection cables necessary for the operation of electric and electronic apparatuses, usually provided on the working planes. such as desks. shop registers, suitable furniture and not. or on the floor, for computers. video games, television sets. HI-FI apparatuses. etc.

With the always bigger diffusion of the use of the electronic apparatuses. both for work and domestic uses. always more evident is the problem connected with the 'managing" of the power and/or connection cables of the various apparatuses. mainly if the panel for the connection of the cables is not faced toward the wall or hidden zone.

Generally speaking, said cables are loosely placed without any protection or covering, thus inducing a remarkable confusion. Particularly intolerable in a domestic environment, where often said apparatuses either computers or relevant accessories, and television sets, video games, etc. are unavoidably provided within commonly used rooms, but it is also remarkable in the work environment, mainly if open to the public.

Furthermore, said situation is a danger, often neglegted, even if not ignored, for the persons beyond a risk of putting out of order the whole system due to reasons absolutely fortuitous and unforeseeable.

At present, only solutions that in some cases are adopted provide the use of various, more or less temporary, systems allowing to gather and fasten the cables all together with the sole result to make them more compact, but also viewable and strikable.

It is also known, from US-A-5286919, a system for managing communication and power cables (vertical and horizontal) associated with a computer system relating the housing of communication or power cables of computers classified as minicomputers or main-frames that usually are housed in one or more cabinets which stand upright on a floor.

A disadvantages of this known managing system for cables, is that the power or communication cables are not completely protected and covered, and it is not suitable for covering cables connecting apparatuses lying on tables and/or on the floor.

These and other results are obtained, according to the present invention, by a solution providing in combination a plurality of components that, suitably combined according to the specific needing, completely hide and protect beside the rear or connection part, cables, said part being also possibly lateral, on the upper part, etc., of the various apparatuses, as well as the various power and/ or connection cables, putting in order the working plane and/or the floor, or in any other possible position.

Another object of the present invention is that of providing a solution allowing to guarantee safety of persons, users and/or visitors, as well as the protection of the cables and of the relevant plugs of the various apparatuses.

Still another object of the present invention is that of providing a practical solution with respect to the assembly; in fact the elements according to the invention can be applied after the connections; furthermore, the solution according to the invention is aesthetically pleasant, in view of the shape of the various components of the invention, beside the avoided confusion.

It is therefore specific object of the present invention a series of elements cases, shells, panels, and channels to cover cables, particularly for apparatuses provided on a working plane and like or on a floor, comprising a case, a shell shaped to conform to the cable connection zone, or at least one of the covering elements to be applied in the cable connection zone to the apparatus, covering cable couplings and the same cables.

Preferably, said cable covering elements can also provide a containment and passage channel for the cables exiting from one of said covering elements, said at least one covering element being provided with means for coupling with said one channel.

According to the invention, said covering elements provide a cable covering case, that will house the working mechanisms of the specific apparatus (computer, monitor, television, video recorder, HI-Fl apparatuses, etc.) comprised of a frame, having a free space, or connection space, behind the cable connection panel, protected by a hinged or restrained rear panel (door), and eventually another front restrained, hinged or slidable element, having the function of front mask for the apparatus.

Preferably, ventilation slots can be provided on said case.

Still according to the invention, said cable covering elements can be completely provided on the apparatus resting plane, or, in case it is on a desk or other similar working plane, they can provide, in correspondence of the base, a slidable element, or, the frame elongated downward, and, on each one of the two lateral elements, both of the slidable element and the frame, one slit allowing to the element to fit in the working plane. In this way the conveyance and the hiding of the cables from and for the under part of the working plane.

In order to conform to any thickness of said plane, lateral elements are provided in correspondence of said slits, said lateral elements being vertically slidable, and stopping and blocking when meet the plane; otherwise, pretagli provided in the lateral part of the frame or of the slidable element, allowing to remove portions of said lateral parts in function of the thickness of the plane.

Furthermore, according to the invention, said cable covering elements can provide an element comprised of a case without the portion covering the electronic and/or electric elements to operate the apparatus, but with the portion necessary to hide the cable connection panel.

Said elements will be indicated as shells and are destined to the covering of those apparatuses the case of which does not provide the cable covering element, such as present computer, video recorders televisions, Hl-FI apparatuses, monitor, printers, cash registers, calculators, etc.

Shells are shaped to conform to the rear portion or the cable connection zone of the specific apparatus, and ventilation slits are provided both on their rear door and on their lateral parts.

Further, said covering element can be realised to conform to the sizes of the apparatus on which it will be mounted.

In fact, it can be horizontally enlarged, particularly providing two lateral parts sliding within an interspace of the frame by frame longitudinal elements, which are slidable each other, for example by a coupling between toothed element and a suitable toothed wheel, and/or by telescopic sliding of the lateral panels, being further provided position blocking means.

Furthermore, according to the invention, said covering element can be modified in height, particularly by the sliding of all the portion above the plane: free space is compensated by replacement elements, preferably by lateral chutes and, on the back part with respect to the apparatus, by the same frame, which is longer downward and blocked by position blocking means.

Said covering elements can be coupled by suitable holes with a channel for the connection with the other apparatuses.

Said channels can be provided in such a way to allow the horizontal or upward and/or downward vertical, or oblique coupling, as well as a multiple coupling.

Always according to the invention, said cable housing and passage channels have a open or semi - open base structure for the horizontal connection, or a completely closed base structure for horizontal, vertical or differently oriented coupling, and eventually frontally provided, with respect to the apparatus, with hales for the passage of the cables, said holes being eventually provided with stoppers.

Preferably, said channels can be comprised of modular elements, preferably fittable each other.

The present invention will be now described, for illustrative but not limitative purposes, according to its preferred embodiments, with particular reference to the figures of the enclosed drawings, wherein:
figure 1 is a perspective rear view of a first cable covering element according to the invention;
figure 2 shows an exploded particular of the element shown in figure 1;
figure 3 is a partially exploded rear perspective view of a second cable covering element according to the invention with the door open, front panel during the fitting phase and a rear slidable element in operation, in the particular case with a plane;
figure 4 shows a particular of the element illustrated in figure 3;
figure 5 is a perspective front view, with front mask and rear panel opened , of third cable covering element according la the invention;
figure 6 is a perspective rear view of a fourth cable covering element according to the invention with the door in a rest position;
figure 7 is a rear perspective view of the element of figure 6 with the door operating and cable covering channels coupled;
figure 8 is a rear perspective view of the element of figure 6 with the door opened and triple stopper for lateral hole;
figure 9 shows a particular of figure 6;
figure 10 is a rear perspective view of a fifth cable covering element according to the invention;
figure 11 is a rear perspective view of the element of figure 10 with the door opened and slidable element extended;
figure 12 is a perspective view of the element of figure IO with a narrowed cable covering element according to the invention;
figures 13 and 14 show a particular of the elements shown in figures 10-12, 15-16, 17, 18 and 19;
figure 15 is a rear perspective view of a further cable covering element according to the invention;
figure 16 is a rear perspective view of the element of figure 15 with the door opened and the slidable element extended;
figure 17 is a rear perspective view of a further cable covering element according to the invention with the slidable element extended, channel coupled and triple stopper for lateral holes;
figure 18 is a partially exploded rear perspective view of the element of figure 17;
figure 19 is a rear perspective view of a further cable covering element according to the invention, said further element being a portion of the element of figure 10;
figure 20 is a rear perspective view of the element of figure 19 coupled with an apparatus, having the channel inserted and the stopper for the hole;
figure 21 is a rear perspective view of a further cable covering element according to the invention, said further element being a portion of the element of figure 1;
figure 22 is a front perspective view of the element of figure 21 with the door opened and plane fitting slidable elements;
figure 23 is a rear perspective view of the element of figure 21 with door opened and pretagli under the plane fitting slit in place of the slidable elements, coupled with the Minitower Power Macintosh G3 manufactured by Apple®, according to the invention;
figure 24 is a partially exploded rear perspective view of a further cable covering element with hole stopper, according to the invention;
figure 25 is a partially exploded front perspective view of the element of figure 24, with an accessary for hooking the slits of some elements;
figure 26 shows a particular of the hooking and of the fitting accessory of the element of figure 24;
figure 27 shows a particular of the element of figure 24;
figure 28 is a perspective view of a channel provided with triple stoppers for lateral holes of the cable covering elements according to the invention;
figure 29 is a bottom perspective view of the element of figure 28;
figure 30 is a perspective view of triple stopper for lateral holes of the cable covering elements according to the invention;
figure 31 is a partially exploded rear perspective view of a cable covering element according to the invention;
figure 32 is a partially exploded front perspective view of the element of figure 31;
figure 33 is a partially exploded rear perspective view of the element of figure 31 with its rear part, including a portion of the lateral parts, elongated toward the base;

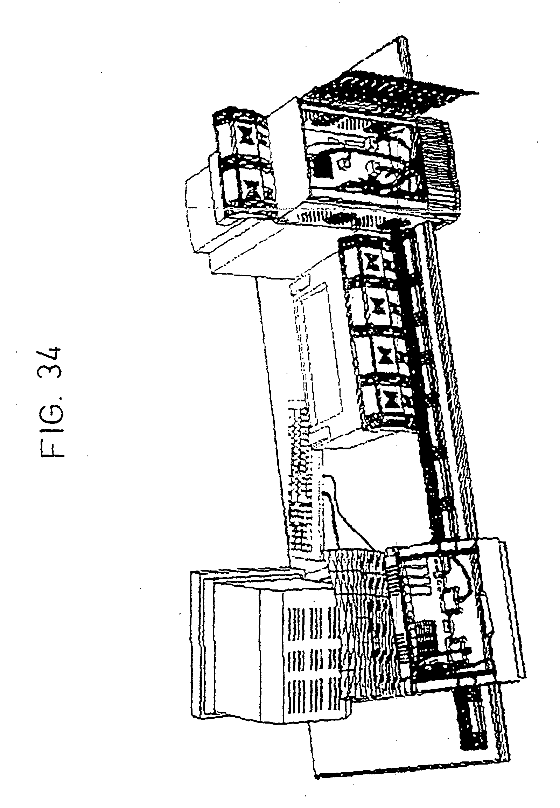

figure 34 shows an example of the elements according to the invention;

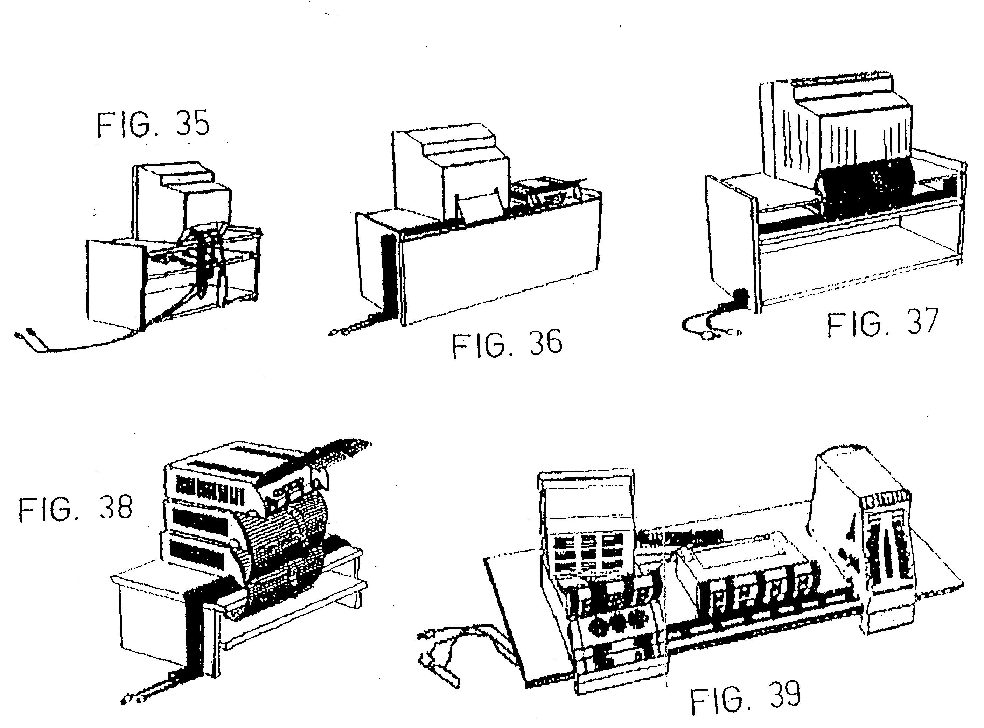

figure 35 shows an example of a real situation of an electronic and electrical apparatus; and
figures 36-39 show use examples of the cable covering elements according to the invention.

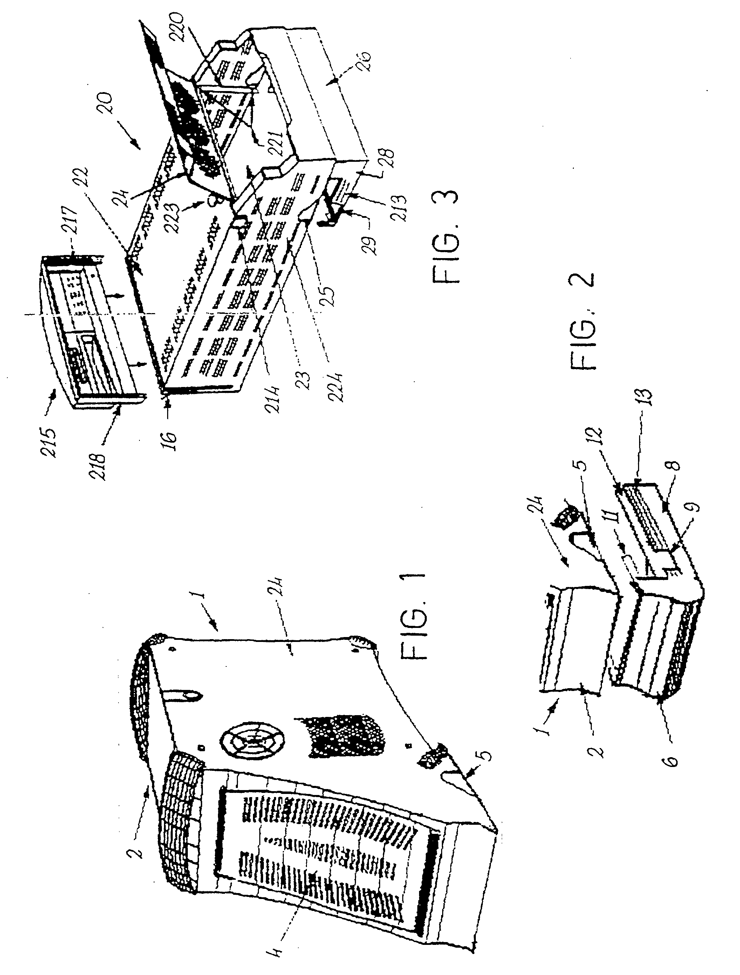

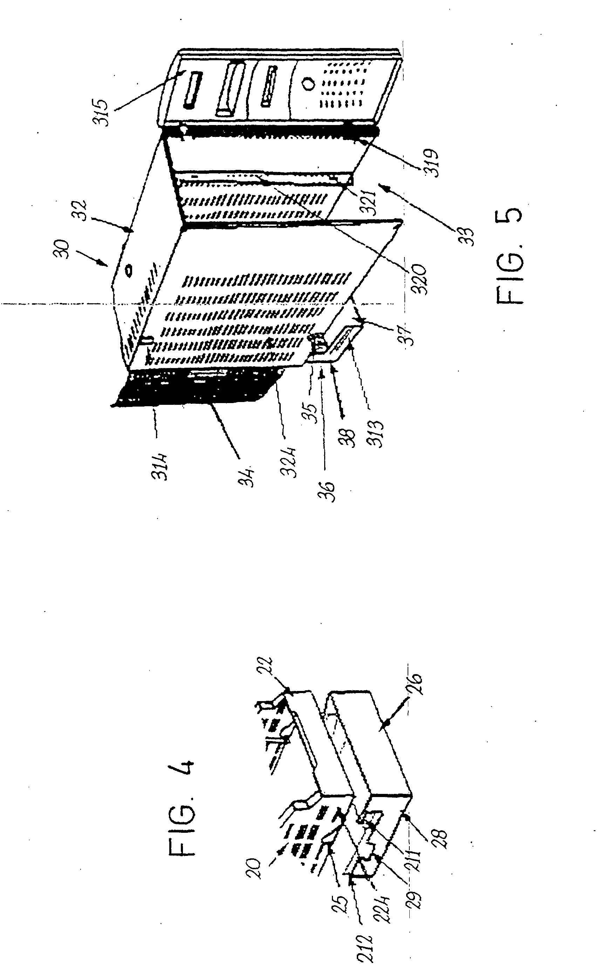

Making reference to the figures of the enclosed drawings, and particularly to figures 1 - 2, 3 - 4 and 5, a first element is shown, generically indicated by reference number 1 (figures 1 - 2), 20 (figures 3 - 4) and 30 (figure 5), respectively realised for a computer to be put on a desk, or on the floor, and particularly Minitower Power Macintosh G3 manufactured by Apple®, (figures 1 and 2), and the desktop or tower, in the other above mentioned figures.

In the following, the situation for the Minitower Power Macintosh G3 manufactured by Apple® will be described in detail, since the situation for the generic desktops and towers are substantially the same of the above mentioned G3, and the corresponding parts will be indicated in the drawings with the same numeral, preceded by the number 2 for desktop and number 3 for tower.

Element 1 provides a frame or case 2 slightly elongated with respect to the inner electric and electronic components, in such a way to obtain a connection room 3, corresponding to the connection plugs of the apparatus rear panel, to protect and contain the connections to operate the computer and to manage the cables. Room 3 is protected by a hinged door 4, allowing the access for any intervention.

Case 2 and door 4 can be holed to allow aeration of the inner components.

Thus, element 1, 20 or 30 covers and protects either the rear panel of the computer and the connections carried out, giving the opportunity of intervening by the door 4 protecting the connection room 3.

On the base of the lateral sides 24 of the case 2, in correspondence of said connection room 3, two shaped holes 5 are provided to house and fit the cable covering channels 110 hiding the connection cables between the computer and its accessories, between the same accessories and/or the other components placed on the plane or on the floor.

The above holes 5 can have a closed base in case it is necessary to support the channels 110 suspended and are further provided with stoppers 120, in case they are not used.

In the inner base of said connection room 3, and accessory is provided, i.e. a slidable element 6 allowing to hide the cables from the rear panel of the computer toward the working plane and vice versa.

Said slidable element 6, when in a rest position, can be housed within the same connection room 3, without any problem. Furthermore, for a better hiding of the cables, said slidable element 6 can be provided with a horizontal plane 7 and holes 8, on the lateral parts 8 of the slidable element 6, coinciding with the lateral holes 5 of the lateral parts 24 of the case 2.

To make it more stable, slidable element 6 can be provided with two elements 11 to rest of the working plane, provided on the upper zones of the lateral pans 8.

In the upper zone of the lateral parts 24 of the case 2 a slit 14 to fit the cable covering accessories can be provided in relief or embedded.

Connection room 3 is delimited by the room housing the functional components of the computer, a stop 20 with holes 21, within which the rear panel of the computer is screwed.

Further, a hole 22, provided with the relevant stopper 23, for the outlet of the cables is provided on the upper base, for connection with components provided on the case.

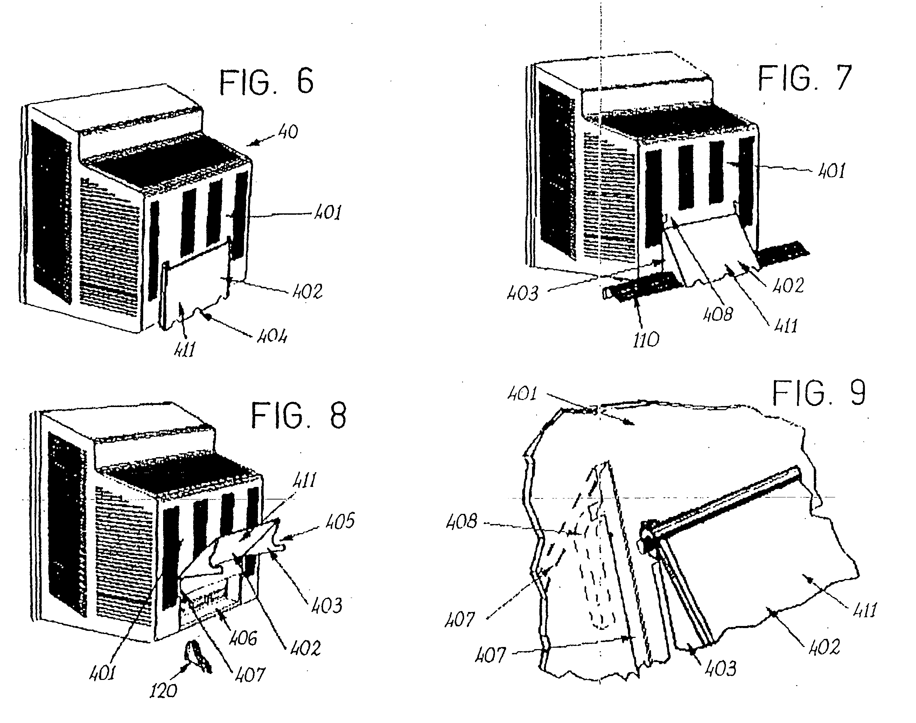

Making reference to the figures of the enclosed drawings, and particularly to figures 6 - 9, it can be seen illustrated according to a preferred embodiment, a new case 40 far television, monitor, video recorders, etc, provided with a frame 401, having holes for aeration of electrical and electronic components, and with a panel 402 (door) covering the cable coupling panel 406, to be fitted in the rear part of the frame 401 of the case 40.

Said door 402 can also be realised foxed with respect to the case 40.

The rear part of the frame 401, in correspondence of the cable connection panel 406 is provided with vertical slits 407, one on each side, to house the lateral parts 403 of the door 402.

Furthermore, on each one of the two lateral parts 403 of the door 402 a shaped hole 405 is realised allowing to the same to house and fit the cable covering channels 110 to contain the connection cables (figure 7) and when lacking, they are closed by suitable stoppers 120.

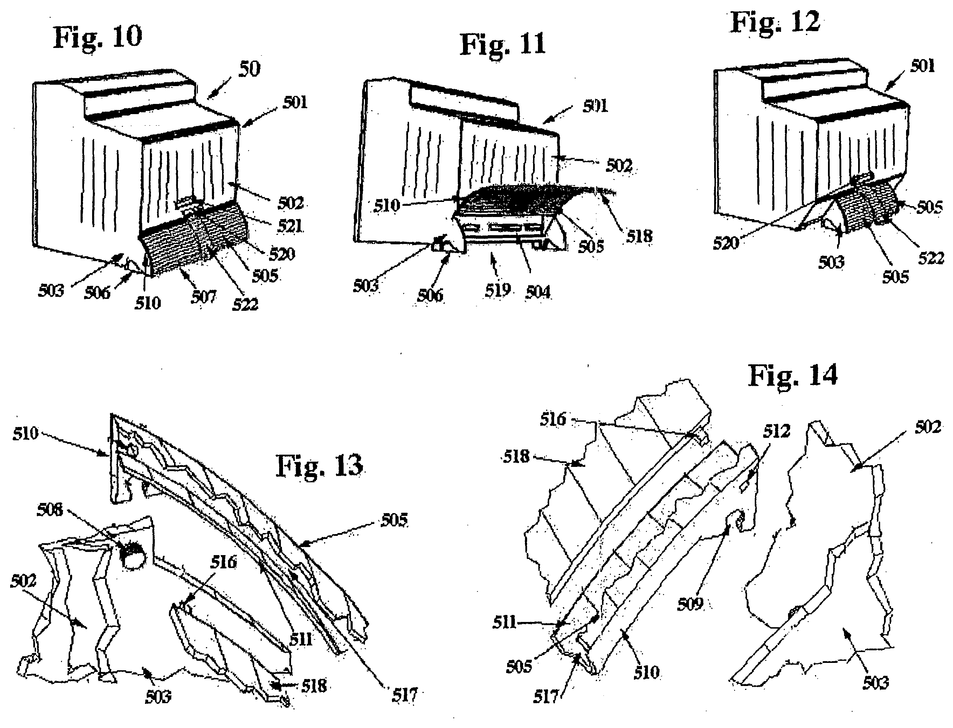

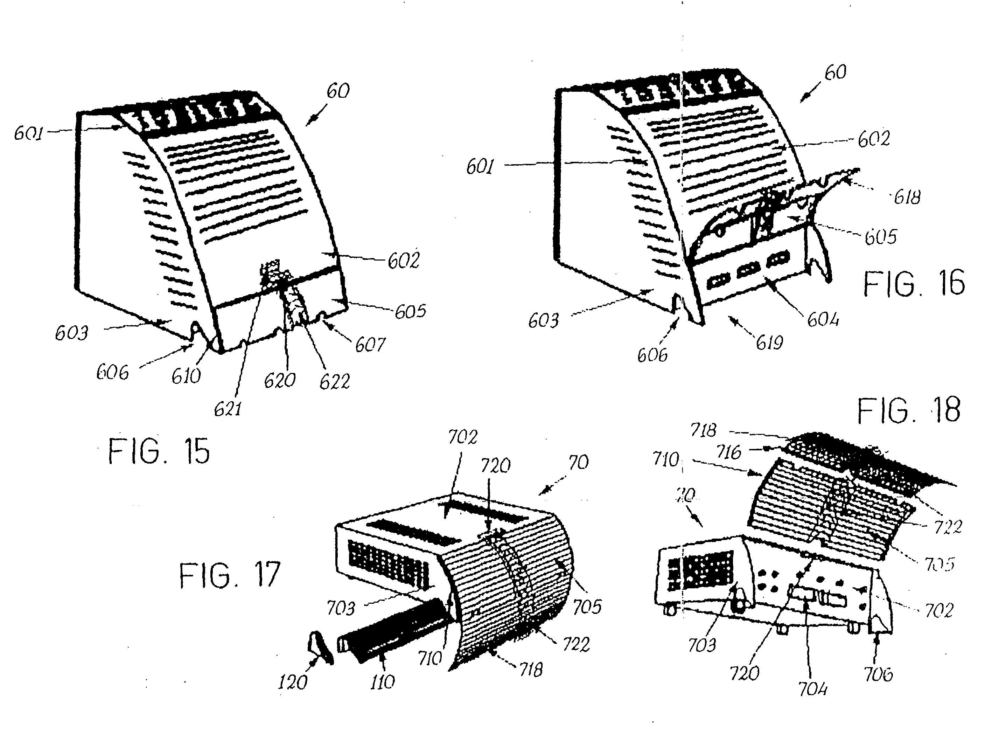

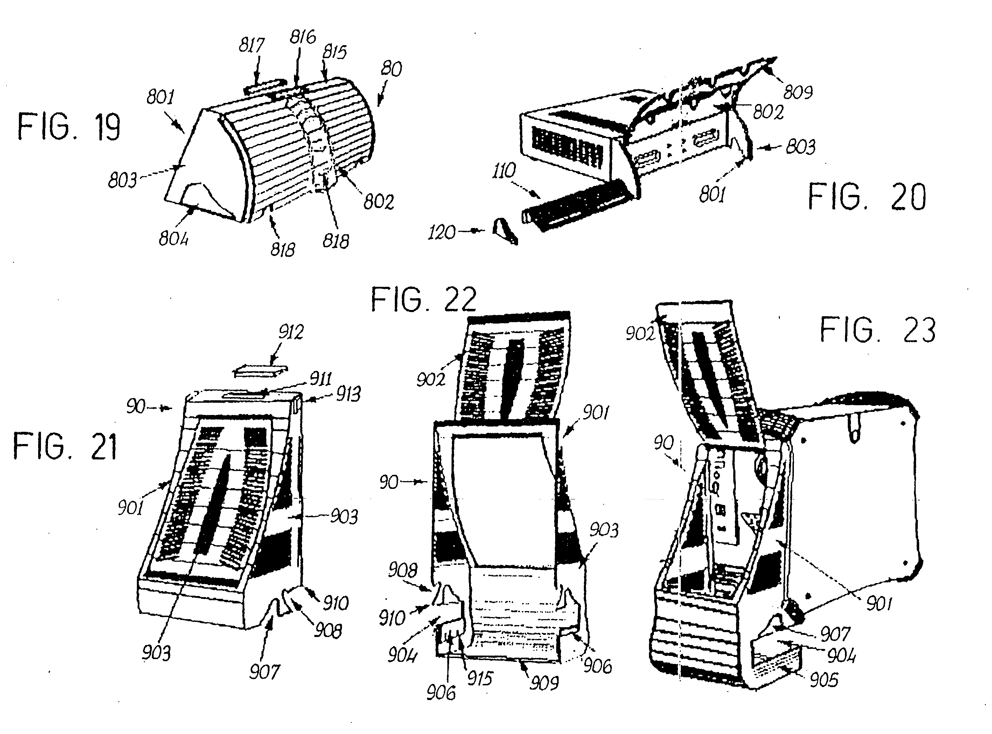

Making reference to the following enclosed drawings, and particularly to figures 10 - 14, 15 - 16 and 17 - 18 and 19, a further element is shown, generically indicated by reference number 50 (figures 15 - 16) and 70 (figures 17- 18) and 80 (figure 19), respectively realised the first two groups for televisions and monitors, and the last group for video recorders, video games, etc.

In the following the solution for television will be described in detail, since the other solutions are substantially the same, but the shape, and the corresponding parts will be indicated in the different figures by the same numeric references, without number 50, but preceded by number 60, those of group of figures 15 - 16, and by number 70, those of group 17 - 18.

Element 50 provides a frame 501, having aeration holes far the electric and electronic components, the lower part of the back portion 502 of which (corresponding to the upper base 702 of the video recorder case, etc.) ending with a door 505 (protecting and covering the cable connection panel 504), fitted and rested an the rear lower ends of the lateral parts 503. Due to space needing, covering can be limited only to the cable connection panel 504 (figure 12).

Within each one of the two lateral parts 510, under the door 505, a base 511 is placed, realising a guide 517 with the door 505, to house and slide a second panel 518, that will allow to hide the cables coming from and/or going under the plane on which element 50 is placed.

Low end of the guide 517 is closed by the base of the lateral part 510, acting as a stop.

The curved shape of the elements 505 and 520, allow to the latter to better hide the cables, putting part of it under the working plane.

On the basis of the lateral parts 503 of the frame 501, in correspondence of the cable connection room 519, two shaped holes 506 are provided, receiving and fitting the cable covering channels 110 to receive the connection cables and in case said channels 110 are not provided, said holes 506 are closed by suitable stoppers 120.

Making reference to the figures of the enclosed drawings, and particularly to figures 19 - 20, a cable covering shell is shown, generically indicated by reference number 80, suitable to cover and protect the rear panel for connection of television, video recorders, Hi-Fi, etc, cables.

As already said, said element 80 corresponds to the already described element 50 (figure 10) without the part covering the operation mechanisms of the specific apparatus, but provided with the sole portion to hide the cable covering panel of the apparatus, having exactly the same characteristics.

A further element of the invention will be now describe, making reference to the figures of the enclosed drawings, and particularly to figures 21 - 23 and 31 - 32, wherein shells are shown, generically indicated by reference number 90 for Apple® G3 computer, and 2001, generically realised for other desktop and lower computers, as already said with reference to cases 1, 20 and 30.

In the following, the solution far Minitower Power Macintosh G3 by Apple® will be described, since the one for generic desktop and tower computers are substantially the same of the above G3.

As already painted out, said elements 90 and 2001 correspond to the elements 1, 20 and 30, without the part covering the operation mechanism of the specific apparatus, but provided with the part to hide the rear panel for the connection of the cables. However, to better clarify, they will be in any case described using specific reference numbers, pointing out that said elements 90 and 2001 are exclusively different as to their size and eventual particulars will be different.

Element 90 provides a frame 901 provided with a door 902 and resting on the positioning plane of the relevant apparatus to cover and protect the cables.

Door 902 and lateral parts 903 of the frame 901 are holed 904 in order to allow the aeration and/or audio exit of the apparatus (it can also provide inside the loudspeakers). From said door 902, it is possible to access within the element to be able to make intervention on the rear panel of the apparatus.

In the solutions shown in figures 22 and 23, prolongation of the frame 901 downward creates on the basis a horizontal plane 909 within the lateral parts 913 of which suits 904 are provided, said slits fitting the apparatus resting plane, allowing a fix coupling with the working plane of the element 90 and the cable conveying under the plane, thus hiding the same.

In the solution shown in figure 21, element 90 is realised for apparatuses provided on a floor or on a working plane not allowing any fitting.

As it can be easily understood from figures 22 and 23, said slits 904 can be widened in function of the resting plane thickness, by a plurality of horizontal pretagli 905 (figure 23), placed on the lateral parts 913, or widened and narrowed by chutes 906 provided on the lateral parts 914, provided within the frame 914, which sliding upward or downward stop abutting under the apparatus resting plane (figure 22).

Just above the slits 904, two shaped holes 907 are provided, one on each side (also with a closed base, figures 22 and 23, in case channels 110 must be suspended), to house and fit the cable covering channels 110 hiding the connection between computer and accessories, between the same accessories and/or the other components placed on the plane, or even cables coming form other locations.

Furthermore, above the element 90 a fitting stopper 911 for a hole 912 could be provided, allowing to convey the cables toward elements placed on the apparatus or toward the ceiling.

Still above, but on the Iateral parts 903 of the frame 901, two slits 914 could be realised, one on each side, to receive the hooking element 1006 of the cable covering panels 100 covering the connection cables for elements placed on the computer (figure 21).

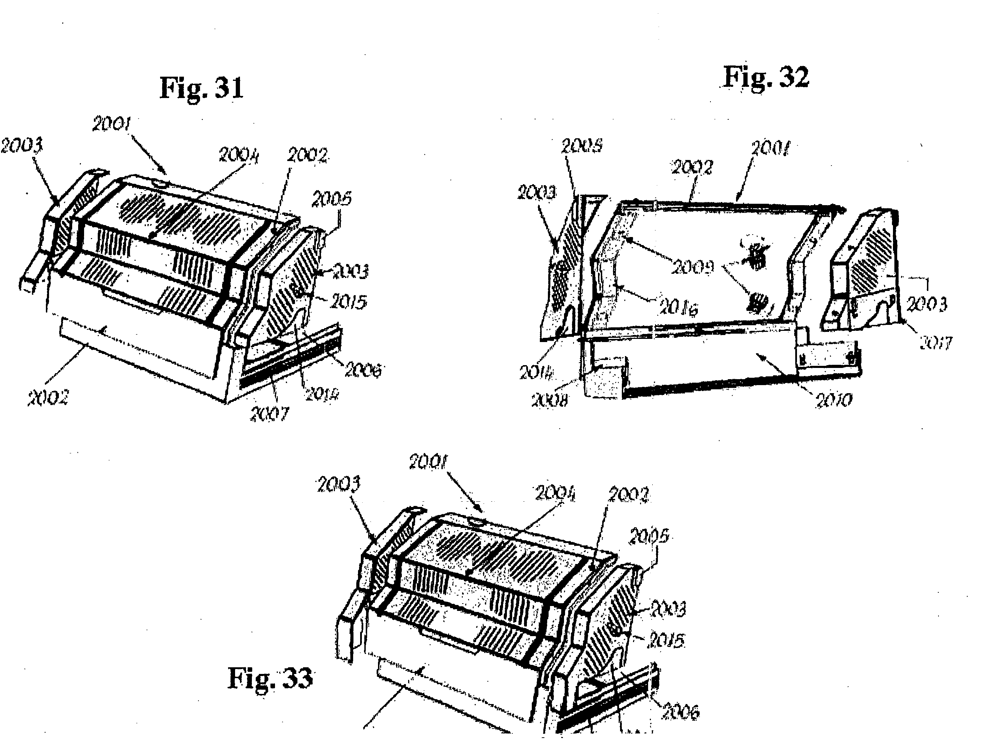

As it can be noted from figures 31 - 33, shells can be extended in width and height, adapting to the dimensions of the computer or apparatus due to the presence of the specific technical solutions provided inside, and particularly shown in figures 31 and 32.

Lateral extension can be obtained by its sliding in both lateral directions 2003 within an interspace created by the element 2016, provided with position stop means, placed above the frame 2001.

Furthermore, according to the invention, said covering element 2001 can be modified in height, particularly by the sliding of all the part above the plane that is overlapped to the apparatus, receiving the same (see figure 23); space between element 2001 and the resting plane of the apparatus is compensated by compensating replacement elements preferably by lateral chutes 2008 provided within the lateral parts 2003 and having position stop means, and, on the back, on the lower part of the same frame 2001, the dimension of which always remains suitable to cover and pass downward the edge of the plane to hide the cables to and from under the plane.

The slidable element 2010 can be placed within the elongation of the frame.

The elongation of the frame 2001 also corresponds to an elongation of the lateral parts 2003, like a side board, acting as spacers from the edge of the plane supporting the apparatus and as hiding lateral elements of the cables.

Handles 2015 can be provided on the lateral parts 2003.

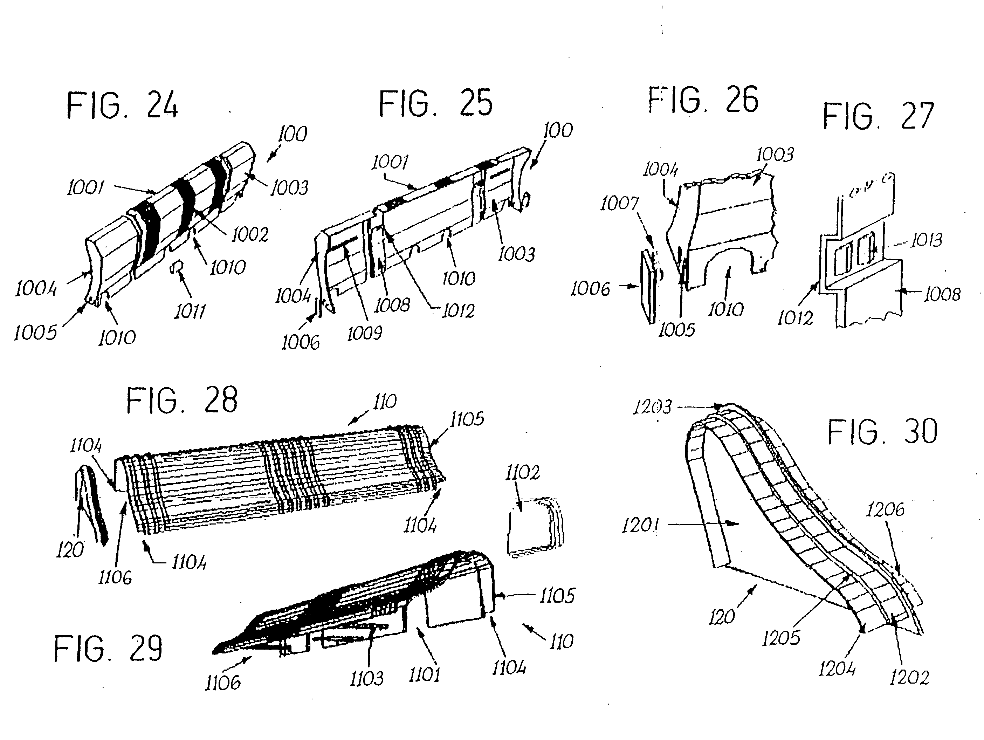

Making now reference to the figures 24 - 27, a cable covering panel is shown, which is generically indicated by reference number 100, to cover the cable connection panel for apparatuses placed on a working plane.

Said panel 100 provides a frame 1001 on which relieves are placed, and can extend to adapt to the dimensions of the specific apparatus.

The variation of the dimensions can occur also laterally, since it is provided with two elements 1003, one on each side, provided with a lateral side board 1004.

Element 1003, running along the interspace created by a further element 1008 placed within the frame 1001, slides and stops by the action of the toothing 1009 provided within the element 1003.

Element 1008 provides an outward projection 1012, within which, in position corresponding to the interspace, two teeth 1013 are provided (see in particular figure 27), horizontally approached with the vertical cut, in such a way to stop any tooth of the toothing 1009.

Further, panel 100 is provided on its base with holes 1010, with the relevant fitting stoppers 1011, corresponding to the holes 1101 of the channels 110, for the passage of the cables, and that will be described in the following.

Panel 100 has its base realised in such a way to fit in the possibie hooking of the channels 110 and its stability is due to the lateral side boards 1004 of the elements 1003 having their base projecting forward.

On said lower part of the lateral side boards 1004, holes 1005 are provided, housing and fitting the hooking element 1006 with the slits 14 of case 1, 20, 30 and with slits 913 of the shell 90.

By the coupling of the hooking 1006 with the holes 1005 of the lateral side boards 1004, panel 100 can be used to cover the cable connection panel from cables of elements placed on the apparatus, hooking the same into the suitable slits 14 of the case 1, 20, 30 and into the slits 913 of the shell 90, 2001.

For connection between the various apparatuses, modular fitting male - female channels 110 are provided (see figures 28 and 29), eventually extensible and/or making part of cases and shells, directly with the suitable connection holes.

Said channels 110 has an open or semi-open base, and provide horizontal elements 1103, alternatively coupled with the two inner edges of said base (figure 29), receiving the cables in the upper space, thus giving the opportunity of making suspended connections between a cable covering element and another one, without the need of resting on a plane.

On channels 110, in correspondence of the lateral parts 1105 and 1106 not connected, fitting stoppers 120 are provided, while on the zone faced toward the computer or other apparatus, holes 1101 are realised, provided with the relevant fitting stoppers 1102, to allow the passage of the cables connecting with the apparatuses.

A further element of the invention is a stopper indicated by the reference number 120 (figure 30), also indicated as "triple stopper" since it can be used to close the lateral holes of cases and shells and the lateral parts 1104 or 1106 of channels 110, notwithstanding the different dimensions of said holes.

Stopper 120 provides a vertical frame 1201 that, being larger than said holes, covers the same.

On said element 1201 little bases are perpendicularly placed in order to fit within said holes, said bases being slightly re-entering with respect to the edge and copying the shape of the perimeter to end before reaching the base in order to bridge on the horizontal element closing the base of some holes.

Base 1202 to be fit in the holes of the cases and of the shells is provided inside with respect to the edge of the element 1201, leaving out of the same the portion 1203 of the frame 1201 acting as stop out of the hole.

Base 1204 to be fit into the large hole 1106 of the channel 110 is placed immediately below the base 1202, exploiting the edge 1205 of the base 1202 as abutment against the channel 110.

Base 1206 is placed on the free face of the frame 1201 and fits into the narrow hole of the element 1105 of the channel 110, exploiting as abutment the same frame 1201.

Finally, in figure 44 an illustrative application is shown, allowing to appreciate all the advantages deriving from the use of the cable covering elements according to the invention.

Furthermore, in figure 45 it is shown a real example, without the use of the invention, while in figures 46-49 some applications are shown for illustrative purposes allowing to appreciate all the advantages deriving from the use of the invention.

## Claims

1. Elements cases (1,20,30,40,50 and 60), shells (80, 90 ,2001, 2050 and 2060), panels (100), and channels (110) to cover cables, particularly for electric and/or electronic apparatuses provided on a working plane and the like or on a floor, comprising at least a covering element to cover and/or contain functional components and the panel for connection of the cables of the apparatus, **characterised in that** said at least one covering element comprises sliding (6, 26, 36,402, 518, 618, 718, 809 and 2010) means suitable to completely cover all the cables in whatever configuration.

2. Cable covering elements according to claim 1. **characterised in that** they provide a covering element (80, 90 and 2001) to be applied behind or in the cable connection zone of the cables to the apparatus or shaped in such a way to couple with the same covering cable couplings and the same cables.

3. Cable covering elements according to claim 1, **characterised in that** they also provide a containment and passage channel (110) for the cables exiting from, or directed toward said covering element, said at least one covering element being provided with means for coupling (5,25,35,405,503,606, 706,804,907,2014 and 2514) with said at least one channel (110).

4. Cable covering elements according to claim 1, **characterised in that**, said covering element provides a shaped frame (2,22,32,401, 501,601,701,801,901 and 2001) and a rear panel or door (4,24,34,402,505,605, 705,802,902 and 2004), said frame (2,22,32,401, 501,601,701,801,901 and 2001) being completely arranged on the apparatus resting plane, orit is provided that said frame (901) is elongated at its base, on the lateral parts of which shaped slits (904) are provided to fit the same to the working plane, in order to convey the connection cables under the same or, still, its rear part (2002), including a portion of the lateral parts, is elongated toward the base to cover and pass the edge of the plane also laterally ; ventilation slots being provided on the lateral parts (24,224,324,903 and 2003) of the said frame (2,22,901 and 2002) and/or on said rear panel (4,24,34, 903 and 2004).

5. Cable covering elements according to the claim 1, **characterized in that** said cable covering elements (1,20, 30 and 2001) provides a slidable element (6,26,36 and 2010) placed within its base, conveying and hiding the connection cables under the working plane from and toward the apparatus, and which, in the rest position, can also be housed within the base into the same element (1,20,30 and 2001); said sliding element (6,26,36 and 2010) providing resting elements (11,211 and 311) ensuring stability and sliding to conform the same to the thickness of the plane.

6. Cable covering elements according to claim 1, **characterised in that** said covering element provides holes (5,25,35,405,503,606,706,804,907, 2014 and 2514) for coupling the channels in such a way to allow the horizontal or upward and/or downward vertical, or oblique coupling, as well as a multiple coupling; said holes in case having the base closed to support the channels suspended.

7. Cable covering elements according to claim 1, **characterised**
**in that** said covering element provides on the high zone of the lateral parts of some elements, slits (214,314,913 and 2005) to fit accessories.

8. Cable covering elements according to claim 1, **characterised in that** said covering element (2001) is widened by telescopic sliding of the lateral panels (2003) with respect to the same frame 2002, said panels being provided with slots (2005), position blocking (2009) means for the same lateral panels (2003) being further provided.

9. Cable covering elements according to claim 1, **characterised in that** said covering element (2001) can be varied in height by the sliding of all the portion above the plane, and thus of the frame (2002), of the lateral panels (2003) and of the rear door (2004), position stop means (2017), the free space created by the height variation upward being laterally compensated by replacement elements, preferably by lateral chutes (2018) and, on the back part with respect to the apparatus, by the same frame (2002), which is longer downward, position blocking means (2017) being also provided.

10. Cable covering elements according to claim 1, **characterised in that** on the back part (401) of some elements (40), two vertical slits (407) are provided, one on each side of the cable coupling panel (406), to fit the lateral parts (403) of one cable covering door (402), provided with means (405) for the coupling with at least one channel (110), as well as its motion and/or sliding.

11. Cable covering elements according to claim 1 **characterised in that** the door (505,605,705 e 802) of some elements is provided with two lateral elements (510,610,710 e 810), thus creating a guide (517 ) by a parallel element (511) placed below the same door (505,605,705 e 802), said guide having also stops.

12. Cable covering elements according claim 1 **characterised in that** the sliding means (518, 618,718 e 809) is a slidable panel placed in the guide (517) under the door (505,605,705 and 805), said panel being provided with stops (516) in the high part of its lateral parts; the door (505,605,705 and 802) and the underlying panel (518, 618,718 e 809) having a curved shape in order to allow to the latter, sliding, to put part of the same under the plane.

## Patentansprüche

1. Kabelschutzhüllen, Case (Gehäuse) (1, 20, 30, 40, 50 und 60), Hüllen (80, 90, 2001, 2050 und 2060), Paneele (100) und Kanäle (110) für Kabelschutzhüllen, besonders für elektrische und/oder elektronische Apparate auf Arbeitsflächen und ähnlichem sowie auf dem Fussboden, die mindestens ein Verkleidungselement miteinschliessen, um sowohl die funktionellen Bestandteile als auch das Kabelanschlusspaneel des Apparats zu verdecken und/oder zu enthalten, die **dadurch gekennzeichnet sind, dass** sie mindestens ein Verkleidungselement aufweisen einschliesslich Gleitelementen (6, 26,36, 402, 518, 618, 718, 809 und 2010), die dazu geeignet sind, die Verdeckung aller Kabel in jeglicher Gestalt zu vervollständigen.

2. Kabelschutzhüllen gemäß Anspruch 1, die **dadurch gekennzeichnet sind, dass** sie ein Verkleidungselement (80, 90 und 2001) vorsehen, das hinter oder im Anschlussgebiet der Kabel des Apparats angebracht wird oder derart gemodelt ist, dass es sich dem Kabelanschlussgebiet anpasst und sowohl die Anschlüsse als auch die entsprechenden Kabel verdeckt.

3. Kabelschutzhüllen gemäß Anspruch 1, die **dadurch gekennzeichnet sind, dass** sie auch einen Kanal (110) zum Enthalten und Durchführen der Kabel von und zum oben genannten Verkleidungselement vorsehen, wobei mindestens ein Verkleidungselement mit einem Verbindungselement (5, 25, 35, 405, 503, 606, 706, 804, 907, 2014 und 2514) zu mindestens einem Kanal (110) versehen sein muss.

4. Kabelschutzhüllen gemäß Anspruch 1, die **dadurch gekennzeichnet sind, dass** sie auch einen gemodelten Rahmen (2, 22, 32, 401, 501, 601, 701, 801, 901 und 2001), ein hinteres Paneel oder eine hintere Klappe (4, 24, 34, 402, 505, 605, 705, 802, 902 und 2004) vorsehen; der vorgenannte Rahmen (2, 22, 32, 401, 501, 601, 701, 801, 901 und 2001) kann komplett auf der für den Apparat bestimmte Stützfläche angebracht werden, oder sie sehen einen an der Basis verlängerten Rahmen (901) vor, der seitlich mit gemodelten Schlitzen (904) zum Einklemmen an der Stützfläche versehen ist, um dort die Kabel unterzubringen, oder sein hinterer Anteil (2002), einschliesslich eines Teils der damit verbundenen Seitenteile, kann in Richtung Basis verlängert werden, um die Stützfläche auch seitlich zu verdecken und zu überragen; an den Seitenteilen (24, 224, 324, 903 und 2003) des Rahmens (2, 22, 901 und 2001) sowie in einigen Fällen an dem oben genannten hinteren Paneel (4, 24, 34, 903 und 2004) sind Lüftungsspalten vorgesehen.

5. Kabelschutzhüllen gemäß Anspruch 1, die **dadurch gekennzeichnet sind, dass** diese Verkleidungselemente (1, 20,30 und 2001) innerhalb der Basis ein Gleitelement (6, 26, 36 und 2010) vorsehen, das die Anschlusskabel von und zum Apparat unter der Arbeitsfläche herführt und verdeckt und das in Ruheposition an der Basis innerhalb des Verkleidungselements (1, 20, 30 und 2001) untergebracht werden kann. Dieses Gleitelement (6, 26, 36 und 2010) sieht Stützelemente (11, 211 und 311) für die Arbeitsfläche vor, die deren Stabilität garantieren und gleiten, um es an die Dicke der Fläche anzupassen.

6. Kabelschutzhüllen gemäß Anspruch 1, die **dadurch gekennzeichnet sind, dass** diese Verkleidungselemente Löcher (5, 25, 35, 405, 503, 606, 706, 804, 907, 2014 und 2514) zur Verbindung zu den Kanälen in waagrechter, senkrechter, aufwärts und/oder abwärts oder schräger Richtung sowie zur vielfältigen Verbindung vorsehen. Diese Löcher können eine geschlossene Basis haben, um hängenden Kanäle zu halten.

7. Kabelschutzhüllen gemäß Anspruch 1, die **dadurch gekennzeichnet sind, dass** diese Verkleidungselemente im oberen Teil der Seitenteile einiger Elemente Ösen (214, 314, 913 und 2005) vorsehen, d.h. Schlitze, um eventuelles Zubehör anzubringen.

8. Kabelschutzhüllen gemäß Anspruch 1, die **dadurch gekennzeichnet sind, dass** diese Verkleidungselemente (2001) durch teleskopische Gleitung der seitlichen Paneele (2003) erweitert und in Bezug auf den Rahmen (2002) mit Ösen (2005) versehen sind; es sind außerdem Haltevorrichtungen (2009) an den seitlichen Paneelen (2003) vorgesehen.

9. Kabelschutzhüllen gemäß Anspruch 1, die **dadurch gekennzeichnet sind, dass** diese Verkleidungselemente (2001) in der Höhe verstellbar sind, und zwar durch Gleitung der gesamten Anlage auf der Arbeitsfläche, d.h. des Rahmens (2002), der seitlichen Paneele (2003) und der hinteren Klappe (2004), da Haltevorrichtungen für die verschiedenen Positionen vorgesehen sind (2017); der durch die Gleitung nach oben freiwerdende Raum wird seitlich durch Ausgleichselemente ausgeglichen, vorzugshalber durch seitliche Gleitelemente (2018) und im Hinterraum des Apparats durch den Rahmen selbst (2002), der nach unten verlängert ist, da er auch mit einer Haltevorrichtung für die jeweilige Position versehen ist (2017).

10. Kabelschutzhüllen gemäß Anspruch 1, die **dadurch gekennzeichnet sind, dass** an der Rückseite (401) einiger Elemente (40) zwei senkrechte Schlitze (407), und zwar einer an jeder Seite im Verhältnis zum Kabelanschlusspaneel (406), vorgesehen sind, zum Einklemmen der Seitenteile (403) einer Kabelverdeckungsklappe (402), versehen mit Mitteln (405) zur Verbindung zum Kanal (110) sowie zu seiner Bewegung und/oder Gleitung.

11. Kabelschutzhüllen gemäß Anspruch 1, die **dadurch gekennzeichnet sind, dass** die Klappe (505, 605, 705 und 802) von einigen Elementen (50, 60, 70 und 80), die mit zwei Seitenteilen (510, 610, 710 und 810) versehen sind, eine Gleitschiene (517) darstellt, und zwar durch ein waagrechtes Element (511), das unter der Klappe (505, 605, 705 und 802) angebracht ist; diese Gleitschiene ist außerdem mit einer endständigen Haltevorrichtung versehen.

12. Kabelschutzhüllen gemäß Anspruch 1, die **dadurch gekennzeichnet sind, dass** in der Gleitschiene (517) unterhalb der Klappe (505, 605, 705 und 802) ein Gleitpaneel (518, 618, 718 und 809) angebracht ist, das im oberen Anteil seiner Seitenteile mit Haltevorrichtungen (516) versehen ist. Die gebogene Form der Klappe (505, 605, 705 und 802) und des darunterliegenden Paneels (518, 618, 718 und 809) gestattet dem letzteren durch Gleitung, einen Teil davon unter der Arbeitsfläche unterzubringen.

## Revendications

1. Eléments cache-câble, enveloppe (1, 20, 30, 40, 50 et 60), coques (80, 90, 2001, 2050 et 2060), Panneaux 100 et canaux 110 Cache-câble, en particulier pour des appareils électriques et/ou électroniques à utiliser sur un plan de travail, similaires et sur le sol, comprenant au moins un élément de couverture pour couvrir et/ou contenir les composants fonctionnels ainsi que le panneau de liaison des câbles des appareils, **caractérisés par** le fait d'avoir au moins un élément de couverture même grâce à des pièces coulissantes (6, 26, 36, 402, 518, 618, 718, 809 et 2010) permettant de compléter la couverture de tous les câbles dans toutes les configurations.

2. Eléments cache-câble selon la revendication 1, **caractérisé par** le fait de prévoir un élément de couverture (80, 90 et 2001) à mettre derrière ou dans la zone de branchement des câbles des appareils ou façonnées de manière à s'adapter parfaitement, recouvrant ainsi les prises et les câbles même.

3. Eléments cache-câble selon la revendication 1 et 2, **caractérisé par** le fait de prévoir en outre aussi un canal (110) pour contenir et permettre le passage des câbles soit à partir du susdit élément de couverture soit pour y arriver.

4. Eléments cache-câble selon la revendication 1, **caractérisé par le fait que** le susdit élément de couverture prévoit un châssis façonné (2, 22, 32, 401, 501, 601, 701, 801, 901 et 2001), un panneau postérieur ou une porte (4, 24, 34, 402, 505, 605, 705, 802, 902 et 2004); susdit châssis (2, 22, 32, 401, 501, 601, 701, 801, 901 et 2001) est entièrement positionnable sur le plan d'appui des appareils ou alors il est pourvu d'un châssis (901) allongé à la base dont sur les latéraux sont prévues des fentes façonnées (904) pour l'emboîtement au plan d'appui même, pour canaliser les câbles ou, même, que sa partie postérieure (2002), y compris une position des latéraux, liés à elle soit allongée vers le bas pour couvrir et outrepasser le bord du plan même latéralement; sur les latéraux (24, 224, 324, 903et 2003) du châssis (2, 22, 901 et 2001) et, dans certains cas, le susdit panneau postérieur (4, 24, 34, 903 et 2004) sont prévues des fissures de ventilation.

5. Eléments cache-câble selon la revendication 1, **caractérisé par le fait que** le susdit élément de couverture prévoit, à l'intérieur de la base, un élément coulissant (6, 26, 36 et 2010) qui canalise et cache les câbles de liaison sous le plan de travail à partir et pour arriver aux appareils et que, en position de repos, peut se loger dans la base à l'intérieur de l'élément même (1, 20, 30 et 2001) ; susdit élément coulissant (6, 26, 36 et 2010) prévoit des éléments d'appuis (11, 211 et 311) au plan de travail qui, outre à en assurer la stabilité, coulissent pour l'adapter à l'épaisseur du plan.

6. Eléments cache-câble selon la revendication 1, **caractérisé par le fait que** le susdit élément de couverture prévoit des trous (5, 25, 35, 405, 503, 606, 706, 804, 907, 2014 et 2514) pour l'accouplement aux canaux en horizontal, vertical vers le haut et/ou vers le bas ou oblique, et en accouplement multiple ; susdits trous peuvent avoir la base fermée pour soutenir les canaux en suspension.

7. Eléments cache-câble selon la revendication 1, **caractérisé par le fait que** le susdit élément de couverture prévoit, sur la zone haute des côtés de certains éléments, des boutonnières (214, 314, 913 et 2005) c'est-à-dire des emboîtements pour y attacher des accessoires éventuels.

8. Eléments cache-câble selon la revendication 1, **caractérisé par le fait que** le susdit élément de couverture (2001) est élargi grâce à un coulissement télescopique des panneaux latéraux (2003) pourvus de boutonnières (2005) par rapport au châssis (2002) même, il est en outre prévu des moyens de blocage des panneaux latéraux (2003) même.

9. Eléments cache-câble selon la revendication 1, **caractérisé par le fait que** le susdit élément de couverture (2001) est modifiable en hauteur grâce au coulissement de toute la partie se trouvant au-dessus du plan, donc du châssis (2002), des panneaux latéraux (2003) et de la porte postérieure (2004), étant prévu un moyen de blocage de la position (2017) l'espace créé avec la régulation en hauteur du coulissement vers le haut est compensé latéralement par des éléments de substitution compensation, de préférence par des pentes latérales (2018) et potérieurement, par rapport à l'appareil, par le même châssis (2002), qui allongé vers le bas, étant en outre prévu des moyens de blocages de la position (2017).

10. Eléments cache-câble selon la revendication 1, **caractérisé par le fait que** sur le dossier (401) de certains éléments (40) sont prévus des fissures verticales (407), une de chaque côté par rapport au panneau de branchement des câbles (406), pour l'emboîtement des latéraux (403) d'une porte cache-câble (402), pourvu de moyens (405) pour l'accouplement avec le susdit canal (110), ainsi que pour son mouvement et/ou coulissement.

11. Eléments cache-câble selon la revendication 1, **caractérisé par le fait que** la porte (505, 605, 705 et 802) de certains éléments (50, 60, 70 et 80), étant muni de deux latéraux (510, 610, 710 et 810), forme une coulisse (517) grâce à un élément horizontal (511) positionné sous la même porte (505, 605, 705 et 802), susdite coulisse est pourvue, en outre, de fin de course.

12. Eléments cache-câble selon la revendication 1, **caractérisé par le fait que** dans la coulisse (517) se trouvant au-dessous de la porte (505, 605, 705 et 802) est positionné un panneau coulissant (518, 618, 718 et 809) pourvu de blocage (516) sur la zone haute de ses latéraux ; la forme courbe de la porte (505, 605, 705 et 802) et du panneau du dessous (518, 618, 718 et 809) permet à ce dernier, en coulissant, de mettre une partie de lui-même sous le plan.
